# EUROPEAN PATENT APPLICATION

(11) **EP 0 829 944 A2**
(43) Date of publication of application: **18.03.1998**
(21) Application number: 97201395.7
(22) Date of filing: 09.05.1997
(51) Int. Cl.: H02K 5/22, H02K 3/50

(54) **Connector for electric motors, in particular for electric motors for washing machines and domestic electrical appliances in general**

(30) Priority: 17.09.1996 IT MI960614 U
(71) Applicant: Wimer S.r.l., 20047 Brugherio (Milano) (IT)
(72) Inventor: Vimercati, Giancarlo, 20047 Brugherio (Milano) (IT)
(74) Representative: Falcetti, Carlo

(57) **Abstract**

Connector for electric motors in which an insulating base (4) is provided with a plurality of grooves (12,13,14,15) for housing enamelled winding wire ends (16,17,18,19), and with a plurality of pairs of channels (20,21,..26,27), transverse to the grooves, the first channel of each pair housing a first anchoring and test terminal (28) which by cutting of insulation establishes an electrical connection with a winding wire end, used for carrying out preliminary electrical tests, before impregnation of the winding and the complete assembling of the motor, or of part of the latter, the second channel of each pair housing a second working terminal (34), engaged in the channel with impregnation carried out, which, by cutting of insulation, establishes an electrical connection with a winding wire end and allows connection with a supply line to the motor.

## Description

The present invention relates to a connector for electric motors, which simplifies the production process and ensures high reliability of electrical contact via terminations of conventional type, preferably with quick or "faston" connection/disconnection but also of other types.

It is known that the production process for electric motors, in particular for their stator, includes various successive phases, such as the formation of the magnetic circuit via lamination packs, the insulation of the winding slots using insulating sheets or sheaths, the insertion of the conducting wire (made of enamelled copper) into the slots, with formation of the winding, attachment of the winding headers, preparation of the winding terminations, with insertion of the enamelled wire terminations into sleeves made of insulating material, and clamping to the terminations of male faston type connector terminals which will subsequently take up their location in a connector base, made of an insulating material, mechanically fixed to a mechanical stator support.

The clamping of the terminals fulfils various functions:
1) It produces electrical contact between terminal and electrical wire by cutting the insulating enamel of the copper wire.
2) It ensures mechanical retention to the insulating sleeve previously fitted to the electrical wire and improves the resistance of the electrical terminations to possible tensile stresses.
3) It allows the carrying out of electrical measurements and tests of insulation and conductivity, before final mechanical rigging.

Subsequently the stator is subjected to an impregnation treatment with insulating material and lastly is mounted in a metal frame, on which is mounted the connector insulating base, onto which the prerigged faston terminations are forced.

Alternatively the impregnation treatment can be carried out subsequent to the installing of the stator into its frame.

In the impregnation operation great care must be taken and suitable provisions made to avoid the insulating varnish being deposited on that part of the faston terminals intended for coupling with a corresponding female faston connector.

All of these operations are arduous and hence expensive.

The handling of the stator also entails the risk of damaging the insulation of the electrical terminals, or of tearing them off, in the course of the electrical measurements, if not adequately fixed to the insulating base, the fixing operation generally being possible only with mechanical rigging accomplished, with the stator housed in its frame.

This is because the irreversible insertion of the terminals into the insulating base generally interferes with the insertion of the stator into its frame.

Finally, even though maximum care is exercised in masking the contact terminals during the impregnation operation there is always the risk of depositing insulating material on them, seriously compromising their reliability.

All of these drawbacks are eliminated by the present invention which in a simple, effective and reliable manner provides a connector for electric motors, which consists of an insulating support base, in which is formed a plurality of grooves, each for housing one of a plurality of enamelled electrical wires, constituting the winding terminations, without requiring special treatment thereof.

Transversely to each groove there is formed a pair of channels, each of which receives and, irreversibly, houses by force, a connector terminal end, preferably a tab, of faston type, shaped like a fork for perforating enamel, which is engaged on the enamelled wire ensuring electrical contact of the wire and its immobilization in the groove.

Beneficially one of the terminals, engaged in one channel of the pair of channels, exhibits minimum or zero expanse outside the insulating base, such as not to interfere, once engaged, with subsequent mechanical operations, such as the insertion and fixing of the stator and of the base inside a frame.

The secure immobilizing of the wires in the grooves of the base makes it possible to slice the end of the enamelled wires to size in a safe manner, flush with a wall of the base.

Moreover, the terminals allow temporary connection with contact clips of electrical test apparatus, subsequent to which the impregnation operation can be carried out.

Only at the conclusion of the production and testing process will the end of a second terminal be engaged in the second channel of each pair, this terminal preferably being of the faston type, shaped like a fork for perforating enamel which ensures reliable electrical contact between wire end and terminal, while the terminal in turn ensures reliable electrical connection, unaffected by impregnation operations, with a terminal, preferably of the female faston type, of a supply wire removably engaged on the male terminal of the base.

Advantageously, according to a particular aspect of the invention, in order to ensure better resistance to the tearing away of the wires and allow greater packing of the terminals, if of the faston type, the grooves for housing the wires each form a run with at least two legs at right angles, the first channel of each pair being arranged perpendicularly to a first of the legs, the second channel of each pair being arranged perpendicularly to the second leg, the second channels, extending in parallel planes equispaced at a predetermined pitch equal to or slightly greater than the expanse of the insulating cowl, of a female faston termination of standard dimensions.

The characteristics and advantages of the invention will emerge more clearly from the description which follows of a preferred embodiment and its variants, given by way of non-limiting illustration with reference to the appended drawings in which:
- Figure 1 represents an overall exploded perspective view of a frame/stator set of an electric motor provided with a connector according to the present invention;
- Figure 2 represents an exploded perspective view of a preferred embodiment of a connector according to the present invention;
- Figure 3 represents a front view of a first variant of the connector of Fig. 2;
- Figure 4 represents a partially exploded perspective view of a second variant of the connector of Fig. 2;
- Figure 5 represents an exploded perspective view of a third variant of the connector of Fig. 2;
- Figure 6 represents an exploded perspective view of a fourth variant of the connector of Fig. 2.

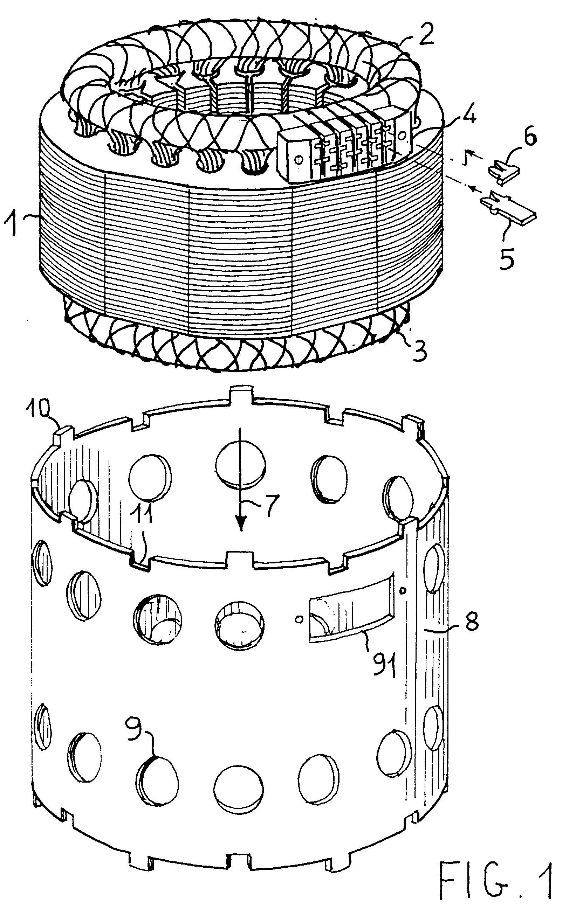

With reference to Fig. 1 a stator/frame set of an electric motor comprises a stator pack 1 of magnetic laminations, strapped in a conventional manner by ties, and in the slots of which is housed a stator winding, closed off on two suitably attached winding heads 2, 3.

Arranged on the lamination pack 1, adjacent to one of the heads, is a connector formed by a base 4 of insulating material, provided with connection and anchoring terminals such as 5, 6, for the end of the winding wires, made of enamelled copper.

The stator set is engaged by force, in the direction indicated by the arrow 7, into a cylindrical frame 8, provided with air vents such as 9, a window 91 for access to the connector base 4, and with teeth and notches (such as 10, 11) for fixing two end caps, not illustrated, provided with bearings for supporting a rotor.

The problem posed by the prior art for this type of stator/frame set is that of furnishing the ends of the winding wires with terminals which can be accessed for electrical test measurements, of inserting the stator pack into the frame, of anchoring the terminals to the connector base and of undertaking the impregnation of the set, with all the drawbacks already mentioned.

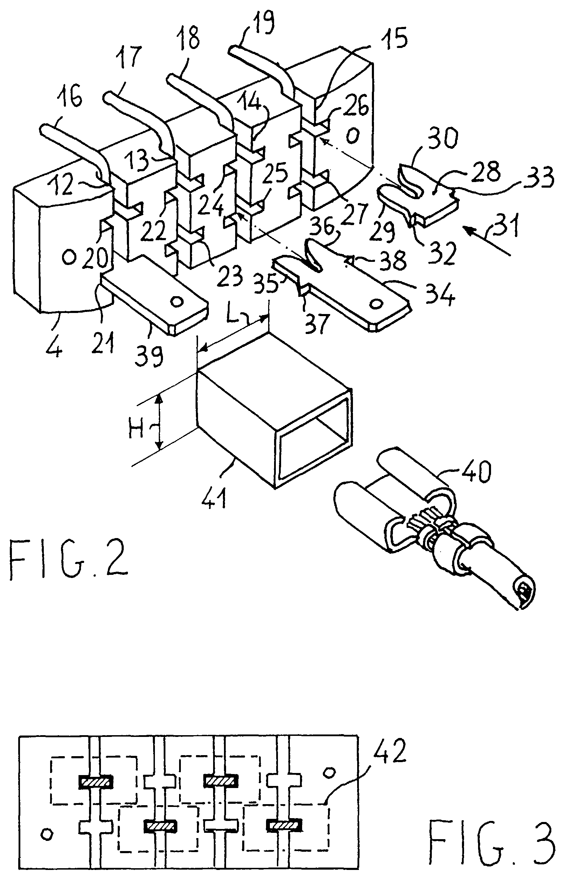

Figure 2 represents an enlarged exploded perspective detail view of the structure of the connector of Fig. 1, made in accordance with the present invention, which solves the technical problem posed by the art.

In Fig. 2 the base 4 of the connector, made from insulating material, is provided with a plurality of side-by-side grooves, for example four such, 12, 13, 14, 15 each for housing one winding wire end, 16, 17, 18, 19 respectively.

The enamelled wire ends are inserted directly into the grooves without any particular or preliminary protective rigging.

A plurality of pairs of channels, 20, 21, 22, 23, 24, 25, 26, 27 respectively, is likewise formed in the connector base 4, the channels of each pair each being arranged transversely to one of the grooves 12, 13, 14, 15.

Grooves and channels open out onto the wall of the base 4 alongside the window 91 for access to the connector, made in the frame 8 (Fig. 1).

Housed in each of the channels is a metal terminal which ensures mechanical anchoring and electrical contact with the end of a conducting winding wire.

Beneficially, but not necessarily, the metal terminals are of two types.

A first type, identified by the numeral 28, consists of a metal tag provided with two flanking end teeth 29,30 which engages fully in a first channel (such as 26) of a pair of channels in the direction indicated by the arrow 31.

Irreversibility of engagement is ensured for example by the interfering of the two ends of the channel with a pair of teeth 32, 33 formed on the flanks of the tag.

With the insertion of the tag 28 into the channel 27, the two flanking end teeth 29, 30 grip the enamelled wire, such as 19, previously arranged in the groove 15, cut through its insulating enamel thereby producing reliable electrical contact with the conducting wire and at the same time ensure the anchoring of the conducting wire to the base 4.

This makes it possible reliably, and without any risk of tearing away the conducting wires, to carry out preliminary electrical measurements (using the accessible part of the anchoring terminals as electrical contact points), to slice off any excess enamelled wire protruding from the grooves, then to insert the stator pack into the frame, since the anchoring terminals, fully inserted into the channels, do not interfere with the frame, and subsequently to carry out impregnation in a tank, without requiring provisions for protecting the anchoring terminals.

It is only when these operations are completed that a terminal of the second type, identified by the numeral 34, is engaged into the second channel of each pair of channels (channels 21, 23, 25, 27 of Fig. 2).

This second type of terminal consists of an elongate metal tag, also provided with two flanking end teeth 35, 36 and with two lateral retaining teeth 37,38, which engages partially in the second channel leaving accessible a connection tab shaped as a conventional male faston terminal, intended to be coupled to a conventional female faston terminal.

In Fig. 2 the numeral 39 identifies a male terminal of the connector intended to be coupled with a corresponding female faston terminal 40 of a supply wire.

Each of the female terminals such as 40 is normally housed in an insulating jacket 41 in the shape of a parallelepiped with a standard width L of 8 mm and a standard height H of 5 mm.

To employ faston terminals intended for coupling with female faston terminals of standard type, it is therefore necessary to space apart the grooves of the connector base 4 by a pitch at least equal to L if it is desired to align the grooves and the relevant terminals inserted therein in two parallel rows, with the terminals of the same type all aligned in the same row.

In the case of connectors provided with a considerable number of terminals, this may entail an unacceptable expanse in terms of length of the connector, to reduce which, as illustrated in Figure 3, the terminals of the second type, depicted in outline, can be arranged in the various channels, alternating them in the two rows with the terminals of the first type.

In this case a compacting of the useful connection terminals is possible, with the sole condition that the pitch between the channels of the same pair is at least equal to H.

In Figure 3 the dashed lines 42 represent the cross-section of expanse of the various jackets 41 intended for insulating the female faston terminals which are coupled with the terminals of the second type.

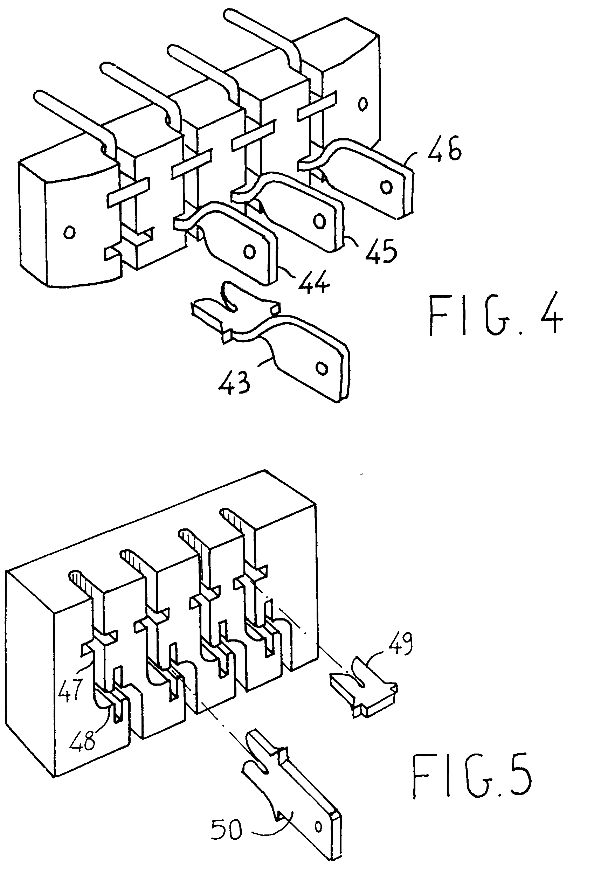

It is however obvious that other solutions are possible: for example Fig. 4 represents a perspective view of a connector in which the insulating base 4 is identical to that of Fig. 2.

However, in this case the connection terminals of the second type or working terminals 43,44,45,46 are twisted in such a way that the toothed ends inserted into the base are all arranged in the same plane, while those portions of the various terminals intended to form a male faston connection are arranged parallel to one another at a pitch at least equal to H.

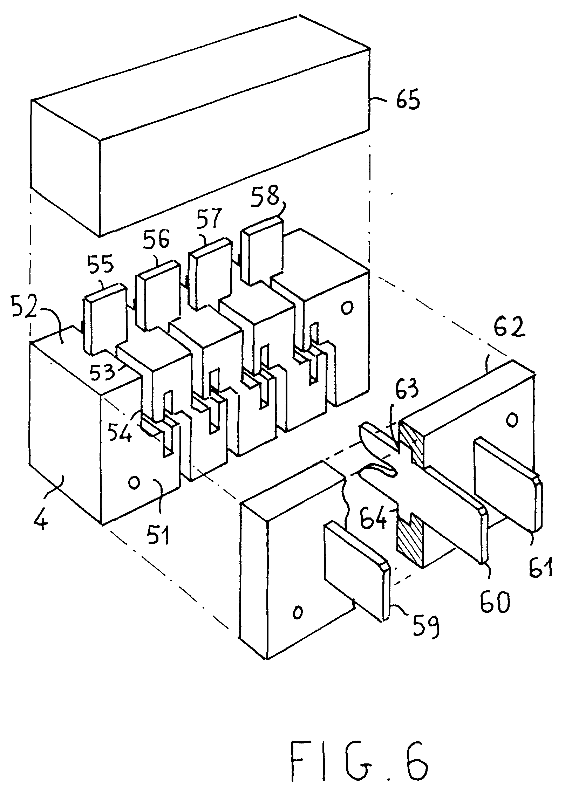

The same result can be achieved, as represented in Fig. 5, without twisting the conducting terminals, by forming various grooves in the insulating base 4 of the connector and which are intended for housing the ends of the winding wires, with a right-angled elbow, in practice beneficially two elbows.

In this way the run formed by each groove comprises at least two legs 47,48 at right angles respectively carved transversely from the first and second channel of a pair of channels, the first channel housing an anchoring terminal 49 of the first type, the second channel housing a connection terminal 50 of the second type.

This solution has the particular merit of ensuring better retention of the anchoring to tensile stresses exerted on the wires.

Figure 6 represents a further variant which combines the merit of the previous one with the advantage also of not requiring the use of connection terminals of two different types.

In Fig. 6 the insulating base 4 for supporting the terminals is provided with a front wall 51 intended to flank a connector access window formed by the stator frame, and with an upper wall 52 accessible from one end of the frame, inside the latter, before closing the frame with end caps.

The various grooves formed in the base 4 in order to house the ends of the stator winding wires extend in this case over both walls 51, 52, forming an intrinsically elbowed run with two legs 53,54 at right angles to one another.

Preferably but not necessarily, the leg 54 formed in the wall 51 is in turn elbowed exactly as in the case of Fig. 5.

The channels for inserting the terminals are formed respectively for the first channel of each pair on the wall 52, perpendicularly to the first leg, and on the wall 51 for the second channel of each pair.

In this way the anchoring and test terminals 55, 56, 57, 58, although identical to the working connection terminals projecting from the surface of the base, do not interfere with the insertion of the stator pack and of the connector into the frame.

Having carried out the rigging of the frame/stator pack set, the connection terminals are then inserted into the respective channels.

Advantageously, as shown in Fig. 6, the connection terminals 59, 60, 61 can be engaged through an insulating safety support 62 which will be fixed to the wall 51 of the base with screws, rivets or other equivalent means.

The terminals 59, 60, 61 can be provided with retaining teeth such as 63, 64 which interlock between the insulating support 62 and the base 4 and prevent relative axial slippage and the detaching of the terminals from the base and from the support, when the latter is fixed to the base.

An insulating cowl 65 can be provided so as to enclose and protect the anchoring and test terminals 55-58 when the frame/stator set is fully rigged.

The foregoing description relates only to preferred embodiments of the invention, and it is clear that many other variants are possible.

For example the connection terminals, employed for the normal working connections, rather than being of the faston type with tab or blade, preferred for their simplicity and convenience of quick connection/disconnection with supply wires, can also be of some other type, for example conformed as binding screws.

## Claims

1. Connector for electric motor, comprising:
- an insulating support (4), forming a plurality of grooves (12,13,14,15) each for housing one of a plurality of enamelled electrical wires (16,17,18,19) separated and insulated from one another by the said support, and constituting winding terminations for the said motor, and a plurality of pairs of channels (20,21,22,...26,27), the channels of each pair each being arranged transversely to one of the said housing grooves, so as each to receive and irreversibly house by force a fork-shaped connector terminal end (29,30) for perforating enamel,
- a first connector terminal (28), engaged in a first channel of each pair in an intermediate phase of the production process for the said motor so as to allow electrical measurements and testing operations following the said intermediate phase of the production process, and
- a second connector terminal (34), engaged in the second channel of each pair at the conclusion of the said production process for connection to the terminal of a supply wire.

2. Connector according to Claim 1, in which the said grooves (12,13,14,15) are rectilinear and parallel to one another and the said pairs of channels (20,21,...26,27) are perpendicular to the said grooves and arranged in two aligned rows parallel to one another.

3. Connector according to Claim 1, in which the said grooves each form a run with at least two legs (47,48) at right angles, the first channel of each pair being arranged perpendicularly to a first (47) of the said legs, the second channel of each pair being arranged perpendicularly to the second (48) of the said legs and perpendicularly to the first channel.

4. Connector according to Claim 3, in which the ends of the said first and second connector terminals are engaged respectively in the said first and second channel of each pair along mutually perpendicular directions of insertion.

5. Connector according to Claims 3 or 4, in which the said second channels of each pair each extend in parallel planes equispaced at a predetermined pitch to form at least one row of equispaced channels.

6. Connector according to the preceding claims, in which the said second connector terminal, engaged in the second channel, is provided with a male faston type connection tab for quick connection.

7. Electric motor provided with a connector according to any one of the preceding claims.
